# EUROPÄISCHE PATENTSCHRIFT

(11) **EP 1 289 007 B1**
(45) Veröffentlichungstag und Bekanntmachung des Hinweises auf die Patenterteilung: **02.11.2005**
(21) Anmeldenummer: 02014551.2
(22) Anmeldetag: 01.07.2002
(51) Int. Cl.: H01L 21/68

(54) **Verfahren und Vorrichtung zum Bonden und Debonden von Systemwafern auf Trägerwafern**
Method and process of bonding and debonding of device wafers to carrier wafers
Méthode et procédé de bondage et dé-bondage des tranches systèmes sur des tranches supports

(30) Priorität: 29.08.2001 DE 10142073
(43) Veröffentlichungstag der Anmeldung: 05.03.2003
(73) Patentinhaber: Infineon Technologies AG, 81669 München (DE)
(72) Erfinder: Hellmund, Oliver, 9500 Villach (AT); von Koblinski, Carsten, Dr., 9500 Villach (AT)
(74) Vertreter: Kindermann, Peter

(56) Entgegenhaltungen:
- EP-A- 0 701 271

## Beschreibung

Die vorliegende Erfindung bezieht sich auf ein Verfahren und eine Vorrichtung, die es erlauben, beliebig große Trägerwafer mit Systemwafern zu verbinden und wieder voneinander zu lösen, wobei die Systemwafer in ihren Abmessungen,geringer oder gleich groß sein können, wie die Trägerwafer.

In der Halbleiterindustrie wird mit Werkzeugen und Equipment gearbeitet, das ebenso Normen unterliegt, wie in anderen Industriezweigen. So ist es üblich, Wafer während deren Prozessierung und auch bei der Nachbearbeitung auf 5, 6 aber auch 8 Zoll-Equipment zu handhaben, was in der Fachsprache dieses Industriezweigs mit "handeln" oder dem Substantiv "Handling" bezeichnet wird. Insbesondere dünne Systemwafer müssen aus Stabilitätsgründen auf sogenannte Trägerwafer montiert werden, damit sie während der Prozessdurchläufe nicht beschädigt werden.

Die Handhabung von dünnen Systemwafern, insbesondere von solchen, die im Durchmesser kleiner sind, als die Trägerwafer, ist oftmals schwierig, denn sie müssen von ihrer Vorderseite, also der strukturierten Seite gehandelt werden. Da die Trägerwafer in den genannten Standardformaten wie 5, 6 oder 8 Zoll zur Verfügung stehen, Systemwafer aber oft nur einen Durchmesser von 2 Zoll aufweisen, werden die Systemwafer mit sogenannten Vakuumchucks an der Vorderseite angesaugt und auf die Trägerwafer montiert. So ist insbesondere die Verwendung von 2-Zoll SiC-Wafer und deren Prozessierung mit den in der Halbleiterindustrie üblichen 5, 6 oder 8 Zoll Trägerwafern üblich. Dazu bedarf es der Montierung - dem Bonden - der Systemwafer auf den Trägerwafern, aber auch der Trennung - dem Debonden - der beiden miteinander verbundenen Wafertypen.

Bei den Bond- bzw. Debond- Prozessen von Systemwafern auf unstrukturierte stabile Trägerwafer muss, - wie bereits erwähnt -, gemäß dem Stand der Technik beim Verbinden der Rückseite des Systemwafers mit einem Trägerwafer die Vorderseite des Systemwafers mit Hilfe eines Werkzeuges, einer Vorrichtung oder dergleichen mechanisch gehandhabt werden. Dazu sind beispielsweise sogenannte Vakuumchucks verwendet worden. Vakuumchucks sind Vorrichtungen, die an der Oberfläche des zu haltenden Werkstücks angesetzt werden und über Öffnungen im Flächenbereich ihres Kontaktes mit dem Werkstück verfügen. Durch diese Öffnungen wird Unterdruck zwischen dem Werkstück und der Vorrichtung erzeugt, so dass das Werkstück vom Vakuumchuck angesaugt wird und gehandhabt werden kann. Derartige Vorrichtungen sind in der einschlägigen Industrie hinlänglich bekannt, siehe z.B die Lehre der Schrift EP0701271.

Nachteilig ist, dass es durch den direkten mechanischen Kontakt einer derartigen Handlinghilfe - wie es beispielsweise ein Vakuumchuck darstellt - mit der Vorderseite des Systemwafers, also mit dessen strukturierter Oberfläche, zu Beschädigungen der Halbleiterstruktur kommen kann.

Insbesondere das Debonden von Systemwafern, welche rückseitig mit Trägerwafern verbunden sind, erfordert ein hohes Maß an mechanischer Einwirkung auf die Systemwafer-Öberfläche, um den Systemwafer wieder von seinem Trägerwafer zu trennen.

Da die Bondierung von System - und Trägerwafern durch Medien, häufig temperaturabhängige Folien, Lacke oder ähnliches erfolgt, erfordert auch das Debonden einen thermischen Prozess, der unter Umständen durch flüssige Medien unterstützt wird. Im Falle eines rein thermischen Debond-Prozesses muss ein entsprechend ausgebildeter Greifer(Vakuumchuck) an der strukturierten Oberfläche des bereits prozessierten Systemwafers angreifen, um diesen vom Trägerwafer abzuheben und an einen vorbestimmten Platz, beispielsweise in eine Aufbewahrungskassette zu verbringen. Wenn der Debond-Prozess durch flüssige Medien unterstützt wird, kann es in Tauchbädern mit Lösungsmitteln o.ä. zum unkontrollierten Lösen des Systemwafers vom Trägerwafer kommen. Der Systemwafer gleitet - nach Einwirkung des flüssigen Mediums auf das Bondmaterial - vom Trägerwafer ab und muss durch eine besondere Vorrichtung oder manuelles Handling in eine Kassette, auch Horde genannt, zurück verbracht werden.

Das bedeutet, dass Systemwafer, die mit ihrer Rückseite auf Trägerwafern montiert sind, bevor sie den eigentlichen Prozessabläufen zugeführt werden, später von der Vorderseite her gehandelt werden müssen, wo sich dann allerdings bereits die Strukturen, d.h. die Halbleiter befinden.

Der Erfindung liegt daher die Aufgabe zugrunde, ein Verfahren und eine Vorrichtung anzugeben, mit denen es möglich ist, Systemwafer verschiedener Größen auf Trägerwafern mit entsprechendem oder größerem Durchmesser, bei Verwendung eines geeigneten Bondmediums, miteinander zu verbinden und wieder zu trennen, ohne dabei Oberflächenstrukturen mechanisch zu belasten, die bereits auf den Systemwafern erzeugt sind.

Diese Aufgabe wird mit einem Verfahren und mit einer Vorrichtung gelöst, deren Merkmale in den Ansprüchen 1 und 6 niedergelegt sind.

Die besonderen Vorteile liegen darin, dass zumindest der Systemwafer während der Bond - bzw. Debond- Prozesse ausschließlich von seiner Rückseite, d.h. von seiner unstrukturierten Oberflächenseite gehandhabt wird.

Weitere Vorteile sind darin zu sehen, dass die Handhabung der System - und der Trägerwafer über getrennt steuerbare Vorrichtungen erfolgt, dass das Bonden und das Debonden mit Hilfe eines Bondmediums erfolgt, sowie darin, dass das Bondmedium zum Bonden und zum Debonden Aufheiz- und Abkühlphasen unterworfen wird und dass die Bond - bzw. Debond- Prozesse unter Vakuum erfolgen.

Eine besonders geeignete Vorrichtung zum Verbinden und Trennen von Wafern unterschiedlicher physikalischer Beschaffenheit, insbesondere zum Bonden und Debonden von Systemwafern und Trägerwafern ist dadurch gekennzeichnet, dass eine Aufnahmevorrichtung zur Aufnahme von wenigstens einem Trägerwafer und wenigstens einem Systemwafer vorhanden ist, und dass zumindest der Trägerwafer über wenigstens einen Durchbruch verfügt, durch den hindurch steuerbare Vorrichtungen an der Rückseite des Systemwafers angreifen. Ferner ist von Vorteil, dass den Trägerwafern und den Systemwafern getrennt steuerbare Vorrichtungen zugeordnet sind, mittels derer sie handhabbar sind, und dass die getrennt steuerbaren Vorrichtungen Bestandteile einer Aufnahmevorrichtung sind, in welcher die Bond- bzw. Debond- Prozesse stattfinden.

Ferner ist eine Vorrichtung besonders vorteilhaft, wenn die getrennt ansteuerbaren Vorrichtungen als SW-Pin-chucks für die Systemwafer und als TW-Pin-chucks für die Trägerwafer ausgebildet sind, und dass die SW-Pin-chucks und die TW-Pin-chucks durch Druck, respektive Unterdruck ansteuerbar sind, wobei in vorteilhafter Weise zumindest die SW-Pin-chucks Dichtungen aufweisen, auf denen die Systemwafer aufliegen und mittels Vakuum ansaugbar sind.

Weitere Vorteile liegen darin, dass die Aufnahmevorrichtung über eine Heizung zum Heizen von Waferstacks verfügt, die aus Trägerwafern und Systemwafern durch Bonden gebildet und durch Debonden getrennt werden.

Mit Hilfe der Zeichnungen soll die Erfindung nachstehend anhand einiger Ausführungsbeispiele noch näher erläutert werden.

Es zeigt:
Figur 1 eine Aufnahmevorrichtung für einen Trägerwafer in Draufsicht;
Figur 2 eine Seitenansicht einer Aufnahmevorrichtung gemäß Figur 1 in Bestückungsposition;
Figur 3 eine Seitenansicht einer Aufnahmevorrichtung gemäß Figur 1 in Bestückungsposition mit angelegtem Vakuum;
Figur 4 eine Draufsicht auf eine mit Trägerwafern bestückte Aufnahmevorrichtung;
Figur 5 eine Seitenansicht einer Aufnahmevorrichtung gemäß Figur 4 mit beschichteten Trägerwafern;
Figur 6 eine Draufsicht auf eine Aufnahmevorrichtung mit gebondeten System- und Trägerwafern;
Figur 7 eine Abfolge verschiedener Verfahrensschritte beim Bonden und beim Debonden;
Figur 8 eine Draufsicht auf eine Aufnahmevorrichtung mit annähernd gleich großen Träger- und Systemwafern;
Figur 9 eine Abfolge von Bond- bzw. Debond- Schritten bei nahezu gleich großen Träger- bzw. Systemwafern;
Figur 10 eine Seitenansicht einer Aufnahmevorrichtung für Waferstacks mit Lösungsmittelkammer und
Figur 11 eine Seitenansicht der Aufnahmevorrichtung gemäß Figur 10 mit getrennten Träger- bzw. Systemwafern.

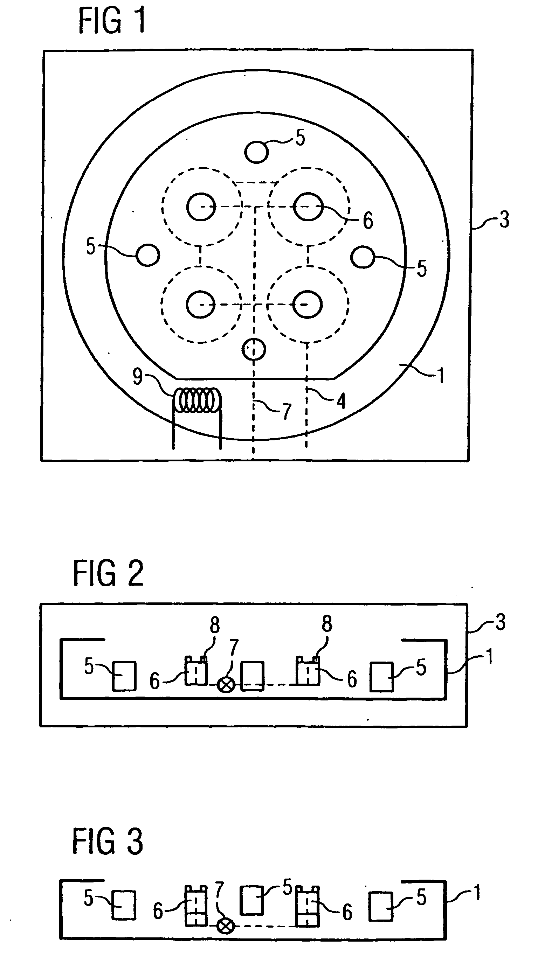

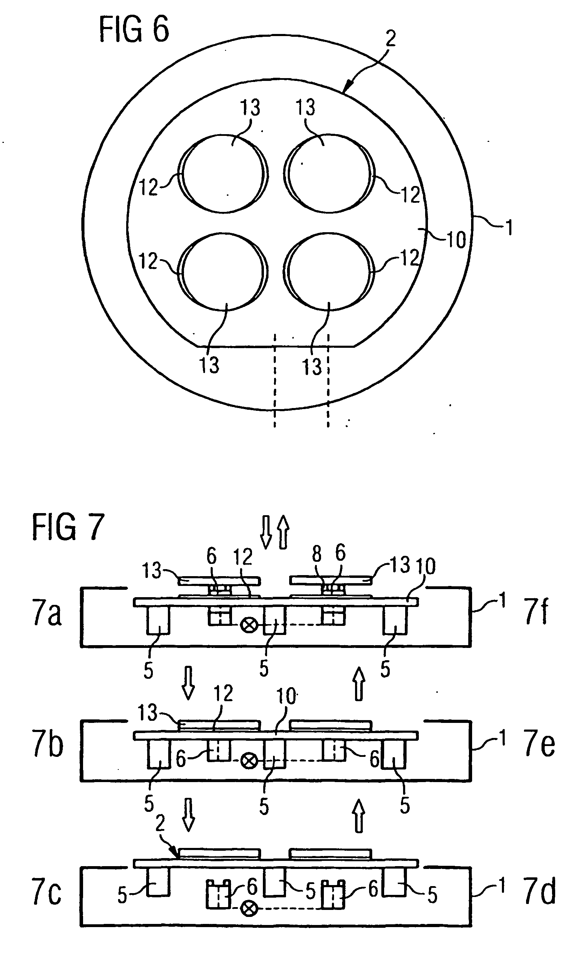

In Figur 1 ist eine Aufnahmevorrichtung 1 zur Aufnahme eines Waferstacks 2 in Draufsicht dargestellt. Ein Waferstack besteht aus zwei miteinander verbundenen Wafern - einem Trägerwafer und einem Systemwafer- und wird später, beispielsweise in Figur 7, noch näher dargestellt und beschrieben. Die Aufnahmevorrichtung 1 befindet sich in einer Vakuumkammer 3, und kann über eine nicht dargestellte externe Evakuierungsleitung evakuiert werden. In der Aufnahmevorrichtung sind sogenannte Pin-chucks 5 und 6 vorhanden. Die Pin-chucks 5 dienen zur Aufnahme wenigstens eines Trägerwafers (hier noch nicht dargestellt) und die Pin-chucks 6 dienen zur Aufnahme eines oder mehrerer Systemwafer (hier ebenfalls noch nicht dargestellt). Zur Verdeutlichung werden sie deshalb als Trägerwafer-Pin-chucks (TW-Pin-chucks) 5 und als Systemwafer-Pin-chucks (SW-Pin-chucks) 6 bezeichnet.

In den Figuren 2 und 3 ist die Aufnahmevorrichtung 1 in verschiedenen Positionen schematisiert im Querschnitt dargestellt, wobei in Figur 3 die Vakuumkammer 3 nicht dargestellt ist. Die Pin-chucks 5 und 6 sind in ihrer Höhe unabhängig von einander ansteuer- und verstellbar. Die SW-Pin-chucks 6 weisen zudem Evakuierungsleitungen 7 auf, mittels der sie mit Hilfe von Unterdruck Systemwafer, welche sich auf ihnen befinden, ansaugen und fixieren können. Um ein Vakuum zwischen dem Systemwafer und dem zugehörigen SW-Pin-chuck 6 aufbauen und erhalten zu können, sind an den SW-Pin-chucks 6 Dichtunggen 8 vorhanden. Systemwafer werden also mit ihren zugeordneten, evakuierbaren SW-Pin-chucks 6 in der Aufnahmevorrichtung 1 gehalten, Trägerwafer werden mittels ihrer zugeordneten TW-Pin-chucks 5 gehoben und abgesenkt, wobei sie in der Vakuumkammer 3 mittels Vakuum gehalten werden. Zum thermischen Bonden bzw. Debonden ist in der Aufnahmevorrichtung 1 eine Heizung 9 eingebaut, mittels der die Bond- respektive Debond-Vorgänge thermisch gesteuert werden können.

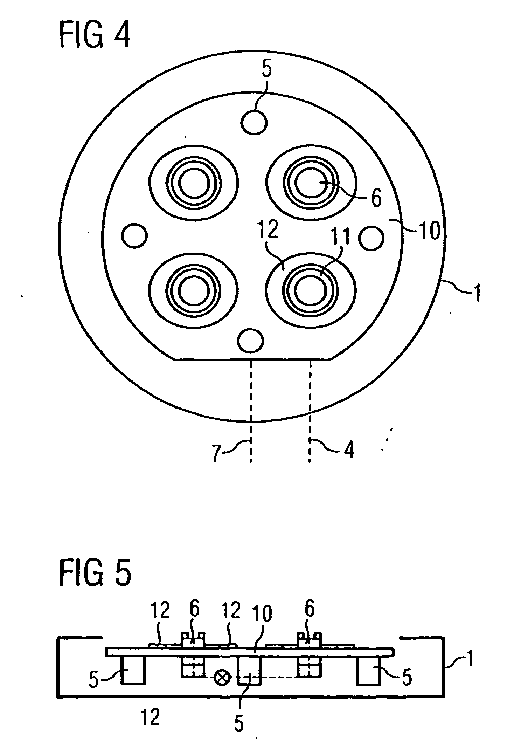

In Figur 4 ist in der Draufsicht eine bereits mit einem Trägerwafer 10 bestückte Aufnahmevorrichtung 1 dargestellt. Die TW-Pin-chucks 5 liegen verdeckt unterhalb des Trägerwafers 10. Im Trägerwafer 10 befinden sich Durchbrüche 11, die so angeordnet sind, dass sie oberhalb der SW-Pin-chucks 6 liegen, so dass diese bei montiertem Trägerwafer 10 ungehindert auf und ab bewegbar sind. Die Durchbrüche 11 werden konzentrisch von einer Schicht Bondmedium 12 umgeben.

Aus Figur 5 ist ersichtlich, dass der Trägerwafer 10 auf seinen TW-Pin-chucks 5 ruht, die SW-Pin-chucks 6 sind ausgefahren und werden von der Schicht Bondmedium 12 umgeben. In dieser Konstellation ist die Aufnahmevorrichtung 1 fertig zur Aufnahme von mehreren Systemwafern, welche hier allerdings noch nicht dargestellt werden. Es ist jedoch ersichtlich, dass die SW-Pin-chucks 6 soweit das Bondmedium 12 überragen, dass die Systemwafer mittels eines hier nicht dargestellten Greifers, der vorzugsweise gabelförmig ausgebildet ist, von der Rückseite her gehandhabt und auf den SW-Pin-chucks 6 abgelegt werden können.

In Figur 6 ist die Aufnahmevorrichtung 1 mit montierten Systemwafern 13 gezeigt. Hier bilden die Systemwafer 13, gemeinsam mit dem Trägerwafer 10, auf dem sie montiert sind, einen Waferstack 2, wie er eingangs bereits kurz beschrieben worden ist. Ein derartiger Waferstack 2 besteht demgemäss aus einem Trägerwafer 10 mit wenigstens einem gebondeten Systemwafer 13 und ist in diesem Stadium bereit, um den verschiedenen Fertigungsprozessen zugeführt zu werden.

In Figur 7 ist dargestellt, mit welchen Verfahrensschritten und in welcher Reihenfolge das Bonden und später dann das Debonden erfolgt. Die linke Seite der Figur stellt dabei die Aufnahmevorrichtung 1 mit dem Bondvorgang dar und auf der rechten Seite ist der Debondvorgang gezeigt. Die Bezugszeichen folgen dabei den jeweiligen Verfahrensschritten.

Schritt 7a stellt die Ausgangssituation dar, in welcher ein Trägerwafer 10 bereits auf seinen zugeordneten TW-Pin-chucks 5 aufliegt und um seine Durchbrüche 11 herum von Bondmedium 12 umgeben ist. Der SW-Pin-chuck 6 ist ausgefahren und überragt den Trägerwafer 10. Von einem gabelförmig ausgebildeten, allerdings nicht dargestellten Greifer ist jeweils ein Systemwafer 13 auf den Dichtungen 8 jeweils eines SW-Pin-chucks 6 abgelegt worden. In Schritt 7b ist der SW-Pin-chuck 6 eingefahren und der Systemwafer 13 liegt auf dem Bondmedium 12 auf, welches erwärmt ist und den Systemwafer 13 auf dem Trägerwafer 10 nach dem Erkalten des Bondmediums 12 fixiert. In Schritt 7c ist das Bondmedium 12 bereits vollständig erkaltet und die TW-Pin-chucks 5 sind ausgefahren, so dass der Waferstack 2 von einem nicht dargestellten Greifer aus der Aufnahmevorrichtung 1 entnommen und den Prozessvorgängen zur Ausbildung der Halbleiterstrukturen zugeführt werden kann.

In der rechten Hälfte der Figur 7 ist in aufsteigender Reihenfolge der Debondvorgang (Schritte 7d bis 7f) schematisch dargestellt. Der fertig strukturierte Systemwafer 13 befindet sich mitsamt seinem Trägerwafer 10 als Waferstack 2 wieder in der Aufnahmevorrichtung 1. Der Waferstack 2 wird mit Hilfe der Heizung 9 aufgeheizt (Schritt 7d), wodurch das Bondmedium 12 an Adhäsionskraft verliert. Dabei wird der Trägerwafer 10 auf seinen TW-Pin-chucks 5 mittels Unterdruck in der nicht dargestellten Vakuumkammer gehalten. Anschließend werden die SW-Pin-chucks 6 von unten gegen die Systemwafer 13 gefahren (Schritt 7e) und heben die Systemwafer 13 von der Schicht des Bondmediums 12 ab (Schritt 7f). Die freien Systemwafer 13 können aus dieser Position nun durch geeignete Greifer von ihren SW-Pin-chucks 6 abgehoben und in Aufbewahrungsstationen verbracht werden. Bei dem gesamten Waferhandling müssen die Wafer nur von ihrer Rückseite her mechanisch angegriffen werden; die auf der Frontseite befindliche Halbleiterstruktur wird keinerlei mechanischer Belastung ausgesetzt.

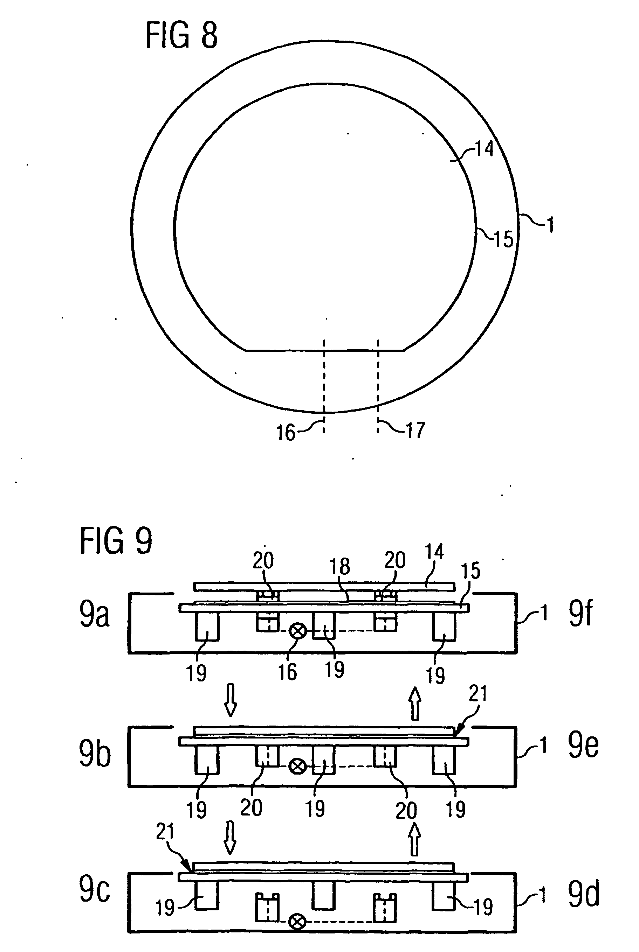

In Figur 8 ist aus der schematischen Darstellung ersichtlich, dass der zu handelnde Systemwafer 14 auch die gleichen, oder nahezu gleichen Abmessungen haben kann, wie der Trägerwafer 15, auf dem er montiert werden soll. In der bildlichen Darstellung deckt der Systemwafer 14 den Trägerwafer 15 vollständig ab, lediglich die Vakuumleitungen 16 und 17 sind als gestrichelte Linien angedeutet sichtbar. Diese Vakuumleitungen 16 und 17 entsprechen funktional den Evakuierungsleitungen 4 und 7 aus der Figur 1.

In der Figur 9 sind nochmals die Vorgänge des Bondens und des Debondens in Schritten 9a bis 9f dargestellt, die analog jenen Schritten 7a bis 7f aus Figur 7 entsprechen. Im ersten Schritt 9a erfolgt das gerichtete Auflegen des bereits mit Bondmedium 18 beschichteten Trägerwafers 15 auf seine zugeordneten TW-Pin-chucks 19. Nach Absenken der TW-Pin-chucks 19 wird der Trägerwafer 15 durch Vakuum in der Aufnahmevorrichtung 1 gehalten. Anschließend wird der Systemwafer 14 auf die ausgefahrenen SW-Pin-chucks 20 gelegt und ggf. durch Vakuum gehalten. Im Falle von thermisch erweichendem Bondmedium 18 - wie es bei diesem Ausführungsbeispiel vorliegt - folgt eine Aufheizphase des Trägerwafers 15 und beim Erreichen des Erweichungspunktes des Bondmediums 18 wird der Systemwafer 14 durch Herunterfahren der SW-Pin-chucks 20 abgesenkt (Schritt 9b) und durch die leichte Zugkraft des Väkuums mit dem Bondmedium 18 verbunden, so dass nun ein Waferstack 21 gebildet worden ist. Der Trägerwafer 15 muss selbstverständlich für eine derartige Aufnahme an den geeigneten Stellen Durchbrüche aufweisen, mit denen die SW-Pin-chucks 20 korrespondieren. Durch Heben des Trägerwafers 15 mittels der TW-Pin-chucks 19 kühlt der Waferstack 21 und somit das Bondmedium 18 ab (Schritt 9c), und der Waferstack 21 kann durch Untergreifen mit einem hier nicht gezeigten Roboterarm von der Aufnahmevorrichtung 1 entfernt werden. Der Roboterarm ist vorzugsweise als Roboter-Vakuum-Chuck ausgebildet.

Das Debonden erfolgt in umgekehrter Reihenfolge und beginnt mit Schritt 9d, bei dem der fertig prozessierte Waferstack 21 auf die ausgefahrenen TW-Pin-chucks 19 aufgelegt und anschließend abgesenkt wird. In dieser Stellung wird er mittels Vakuum in der Aufnahmevorrichtung 1 gehalten und über den Erweichungspunkt des Bondmediums 18 hinaus aufgeheizt (Schritt 9e). Anschließend heben die ausfahrenden SW-Pin-chucks 20 den Systemwafer 14 mit zunehmend erweichendem Bondmedium 18 den Systemwafer 14 vom Trägerwafer 15 ab (Schritt 9f) und ein nicht dargestellter Roboter-Chuck kann durch Untergreifen den Systemwafer 14 aufnehmen und in eine Aufbewahrungsstation, etwa eine Horde oder Kassette transportieren. Anschließend wird der Trägerwafer 15 ebenfalls durch Untergreifen und Anheben aus der Aufnahmevorrichtung 1 entnommen.

Der gesamte Bond- und Debond-Prozess kann unter von außen angelegtem Vakuum erfolgen.

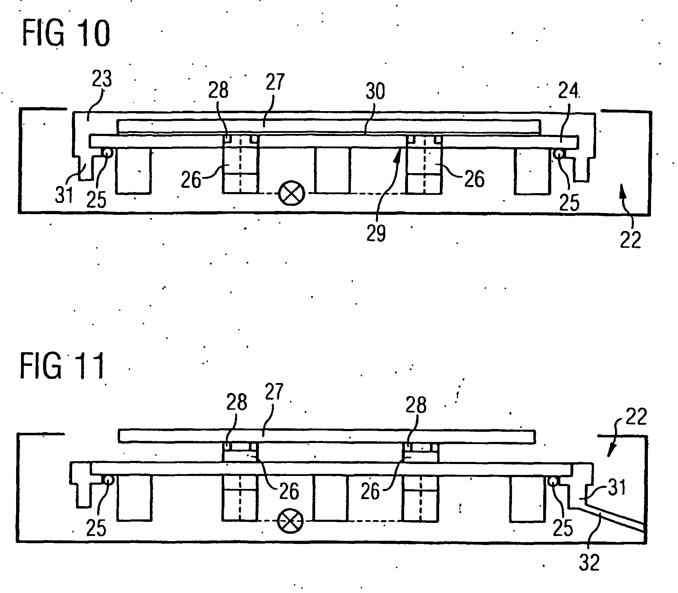

In den Figuren 10 und 11 ist eine weitere Ausgestaltungsmöglichkeit der Erfindung dargestellt. Dazu kann die Aufnahmevorrichtung 22 so gestaltet sein, dass der Debondvorgang durch Lösungsmittel 23 unterstützt wird. Dazu ist zwischen der Aufnahmevorrichtung 22 einerseits und dem Trägerwafer 24 anderseits eine Vakuumabdichtung 25 vorhanden. Ferner ist zwischen dem SW-Pin-chuck 26 und dem Systemwafer 27 eine Vakuumdichtung 28 vorgesehen. Diese Dichtungen 25 und 28 verhindern das Eindringen von flüssigem Medium bei anliegendem Vakuum. In der Darstellung aus Figur 10 ist ersichtlich, das aus dem Trägerwafer 24 und dem Systemwafer 27 ein Waferstack 29 gebildet ist, bei dem der Trägerwafer 24 mit dem Systemwafer 27 durch ein Bondmedium 30 in der vorbeschriebener Weise miteinander verbunden worden ist.

Wie aus Figur 10 und 11 deutlich wird, ist für den Fall des Lösungsmittel-unterstützten Debondvorgangs die Aufnahmevorrichtung 22 mit flüssigem Lösungsmittel 23 gefüllt, welches das Debond-Medium darstellt. Mit fortschreitendem Debondvorgang , in welchem das Debond-Medium 23 das Bondmedium 30 auflöst (Aufquellen des Bondmediums 30) werden die SW-Pin-chucks 26 nach oben gefahren und trennen dabei den Systemwafer 27 vom Trägerwafer 24. Die Aufnahmevorrichtung 22 weist einen Graben 31 zur Aufnahme und eine entsprechende Ablaufvorrichtung 32 zur Entsorgung des flüssigen Debond-Mediums 23 auf.

### Bezugszeichenliste

- 1: Aufnahmevorrichtung
- 2: Waferstack
- 3: Vakuumkammer
- 4: Evakuierungsleitung
- 5: TW-Pin-chuck
- 6: SW-Pin-chuck
- 7: Evakuierungsleitung
- 8: Dichtung
- 9: Heizung
- 10: Trägerwafer
- 11: Durchbrüche
- 12: Bondmedium
- 13: Systemwafer
- 14: Systemwafer
- 15: Trägerwafer
- 16: Vakuumleitung
- 17: Vakuumleitung
- 18: Bondmedium
- 19: TW-Pin-chuck
- 20: SW-Pin-chuck
- 21: Waferstack
- 22: Aufnahmevorrichtung
- 23: Debond-Medium
- 24: Trägerwafer
- 25: Dichtung
- 26: SW-Pin-chuck
- 27: Systemwafer
- 28: Dichtung
- 29: Waferstack
- 30: Bondmedium
- 31: Graben
- 32: Ablaufvorrichtung

## Patentansprüche

1. Verfahren zum Bonden und Debonden von Systemwafern und Trägerwafern,
**dadurch** gekennzeicnet, dass zumindest der Systemwafer (13, 14, 27) während der Bond - bzw. Debond-Prozesse ausschließlich von seiner Rückseite, d.h. von seiner unstrukturierten Oberflächenseite durch wenigstens einen im Trägerwafer (10, 15, 24) vorhandenen Durchbruch (11) hindurch gehandhabt wird.

2. Verfahren nach Anspruch 1, **dadurch** gekennzeicnet, dass die Handhabung der System - (13, 14, 27) und der Trägerwafer (10, 15, 24) über getrennt steuerbare Vorrichtungen (6, 20, 26; 5, 19) erfolgt.

3. Verfahren nach Anspruch 1, **dadurch** gekennzeicnet, dass das Bonden und das Debonden mit Hilfe eines Bondmediums (12, 18, 30) erfolgt.

4. Verfahren nach Anspruch 3, **dadurch** gekennzeicnet, dass das Bondmedium (12, 18, 30) zum Bonden und zum Debonden Aufheiz- und Abkühlphasen unterworfen wird.

5. Verfahren nach Anspruch 1, **dadurch** gekennzeicnet, dass die Bond - bzw. Debond- Prozesse unter Vakuum erfolgen.

6. Vorrichtung mit zumindest einem Trägerwafer zum Bonden und Debonden von Systemwafern und Trägerwafern,
**dadurch** gekennzeicnet, dass eine Aufnahmevorrichtung (1, 22) zur Aufnahme von wenigstens einem Trägerwafer (10, 15, 24) und wenigstens einem Systemwafer (13, 14, 27) vorhanden ist, und dass zumindest der Trägerwafer (10, 15, 24) über wenigstens einen Durchbruch (11) verfügt, durch den hindurch steuerbare Vorrichtungen (6, 20, 26) an der Rückseite des Systemwafers (13, 14, 27) angreifen können.

7. Vorrichtung nach Anspruch 6, **dadurch** gekennzeicnet, dass der Trägerwafer (15) größer oder gleichgroß ist, wie der Systemwafer (14).

8. Vorrichtung nach Anspruch 6, **dadurch** gekennzeicnet, dass den Trägerwafern (10, 15, 24) und den Systemwafern (13, 14, 27) getrennt steuerbare Vorrichtungen (5, 19; 6, 20, 26) zugeordnet sind, mittels derer sie handhabbar sind.

9. Vorrichtung nach Anspruch 8, **dadurch** gekennzeicnet, dass die getrennt steuerbaren Vorrichtungen (5, 19; 6, 20, 26) Bestandteile einer Aufnahmevorrichtung (1, 22) sind, in welcher Bond- bzw. Debond- Prozesse stattfinden.

10. Vorrichtung nach Anspruch 8, **dadurch** gekennzeicnet, dass die getrennt ansteuerbaren Vorrichtungen als SW-Pin-chucks (6, 20, 26) für die Systemwafer (13, 14, 27) und als TW-Pin-chucks (5, 19) für die Trägerwafer (10, 15, 24) ausgebildet sind.

11. Vorrichtung nach Anspruch 10, **dadurch** gekennzeicnet, dass die SW-Pin-chucks (6, 20, 26) und die TW-Pin-chucks (5, 19) durch Druck, respektive Unterdruck ansteuerbar sind.

12. Vorrichtung nach Anspruch 10, **dadurch** gekennzeicnet, dass zumindest die SW-Pin-chucks (6,20, 26) Dichtungen (8, 28) aufweisen, auf denen die Systemwafer (13, 14, 27) aufliegen und mittels Vakuum ansaugbar sind.

13. Vorrichtung nach Anspruch 6, **dadurch** gekennzeicnet, dass die Aufnahmevorrichtung (1, 22) über eine Heizung (9) zum Heizen von Waferstacks (2, 21, 29)verfügt, die aus Trägerwafern (10, 15, 24)und Systemwafern (13, 14, 27) durch Bonden gebildet und durch Debonden getrennt werden.

14. Vorrichtung nach Anspruch 6, **dadurch** gekennzeicnet, dass sie dergestalt eingerichtet ist, dass das Bondmedium (12, 18, 30) durch eine Heizung (9) thermisch beeinflussbar ist.

15. Vorrichtung nach Anspruch 6, **dadurch** gekennzeicnet, dass die Aufnahmevorrichtung (22) über einen Graben (31) zur Aufnahme eines Debond-Mediums (23) verfügt.

16. Vorrichtung nach Anspruch 15, **dadurch** gekennzeicnet, dass der Graben (31) mit einer Ablaufvorrichtung (32) zum Entsorgen des Debond-Mediums (23) verbunden ist.

17. Vorrichtung nach Anspruch 15, **dadurch** gekennzeicnet, dass sie dergestalt eingerichtet ist, dass als Debond-Medium, (23) ein Lösungsmittel benühzt werden kann.

18. Vorrichtung nach Anspruch 6, **dadurch** gekennzeicnet, dass der Trägerwafer (10, 15, 24) aus einem Werkstoff mit ähnlichen physikalischen Eigenschaften -z. B. Temperaturkoeffizienten - besteht, wie der zu tragende Systemwafer (13, 14, 27).

19. Vorrichtung nach Anspruch 18 , **dadurch** geken nzeicnet, dass der Trägerwafer (10, 15, 24) aus einem Werkstoff wie Quarzglas, Kunststoff oder dergleichen besteht.

## Claims

1. Method for bonding and debonding device wafers and carrier wafers, **characterized in that** at least the device wafer (13, 14, 27) is handled during the bonding and debonding processes exclusively from its back side, i.e. from its side with an unpatterned surface, through at least one aperture present in the carrier wafer.

2. Method according to Claim 1, **characterized in that** the handling of the device wafers (13, 14, 27) and the carrier wafers (10, 15, 24) takes place by means of separately controllable devices (6, 20, 26; 5, 19).

3. Method according to Claim 1, **characterized in that** the bonding and debonding takes place with the aid of a bonding medium (12, 18, 30).

4. Method according to Claim 3, **characterized in that**, for the bonding and/or debonding, the bonding medium (12, 18, 30) is subjected to heating and cooling phases.

5. Method according to Claim 1, **characterized in that** the bonding and debonding processes take place under a vacuum.

6. Apparatus with at least one carrier wafer for bonding and debonding device wafers and carrier wafers, **characterized in that** a receiving device (1, 22) for receiving at least one carrier wafer (10, 15, 24) and at least one device wafer (13, 14, 27) and also at least one carrier wafer are present, the carrier wafer (10, 15, 24) having at least one aperture (11), through which controllable devices (6, 20, 26) can act on the back side of the device wafer (13, 14, 27).

7. Apparatus according to Claim 6, **characterized in that** the carrier wafer (15) is larger than or the same size as the device wafer (14).

8. Apparatus according to Claim 6, **characterized in that** the carrier wafers (10, 15, 24) and the device wafers (13, 14, 27) are assigned separately controllable devices (5, 19; 6, 20, 26), by means of which they can be handled.

9. Apparatus according to Claim 8, **characterized in that** the separately controllable devices (5, 19; 6, 20, 26) are component parts of a receiving device (1, 22), in which bonding and debonding processes take place.

10. Apparatus according to Claim 8, **characterized in that** the separately activatable devices are formed as DW pin chucks (6, 20, 26) for the device wafers (13, 14, 27) and as CW pin chucks (5, 19) for the carrier wafers (10, 15, 24).

11. Apparatus according to Claim 10, **characterized in that** the DW pin chucks (6, 20, 26) and the CW pin chucks (5, 19) can be activated by pressure, or negative pressure.

12. Apparatus according to Claim 10, **characterized in that** at least the DW pin chucks (6, 20, 26) have seals (8, 28), on which the device wafers (13, 14, 27) rest and to which they can be attached by suction by means of a vacuum.

13. Apparatus according to Claim 6, **characterized in that** the receiving device (1, 22) has a heater (9) for heating wafer stacks (2, 21, 29), which are formed from carrier wafers (10, 15, 24) and device wafers (13, 14, 27) by bonding and are separated by debonding.

14. Apparatus according to Claim 6, **characterized in that** it is set up in such a way that the bonding medium (12, 18, 30) can be thermally influenced by a heater (9).

15. Apparatus according to Claim 6, **characterized in that** the receiving device (22) has a channel (31) for receiving a debonding medium (23).

16. Apparatus according to Claim 15, **characterized in that** the channel (31) is connected to a discharge device (32) for the disposal of the debonding medium (23).

17. Apparatus according to Claim 15, **characterized in that** it is set up in such a way that a solvent can be used as the debonding medium (23).

18. Apparatus according to Claim 6, **characterized in that** the carrier wafer (10, 15, 24) consists of a material with similar physical properties - for example thermal coefficient - as the device wafer (13, 14, 27) to be carried.

19. Apparatus according to Claim 18, **characterized in that** the carrier wafer (10, 15, 24) consists of a material such as quartz glass, plastic or the like.

## Revendications

1. Procédé pour lier et délier des tranches systèmes et des tranches supports, **caractérisé en ce que** l'on manipule, en passant à travers au moins une traversée prévue dans la tranche support, au moins la tranche (13, 14, 27) système pendant les opérations de liaison et de déliaison exclusivement par son côté arrière, c'est-à-dire par son côté de surface qui n'est pas structuré.

2. Procédé suivant la revendication 1, **caractérisé en ce que** l'on effectue la manipulation du système (13, 14, 27) et de la tranche support (10, 15, 24) par des dispositifs (6, 20, 26 ; 5, 19) pouvant être commandés séparément.

3. Procédé suivant la revendication 1, **caractérisé en ce que** l'on effectue la liaison et la déliaison à l'aide d'un milieu (12, 18, 30) de liaison.

4. Procédé suivant la revendication 3, **caractérisé en ce que** l'on soumet le milieu (12, 18, 30) de liaison à des phases de chauffage et de refroidissement pour la liaison et pour la déliaison.

5. Procédé suivant la revendication 1, **caractérisé en ce que** l'on effectue les opérations de liaison et de déliaison sous vide.

6. Dispositif comprend au moins une tranche support pour la liaison et la déliaison de tranches systèmes et de tranches supports, **caractérisé en ce qu'**il y a un dispositif (1, 22) de réception d'au moins une tranche (10, 15, 24) support et d'au moins une tranche (13, 14, 27) système ainsi qu'au moins une tranche support, la tranche support (10, 15, 24) disposant d'au moins une traversée (11) à travers laquelle des dispositifs (6, 20, 26), qui peuvent être commandés, peuvent attaquer le côté arrière de la tranche système (13, 14, 27).

7. Dispositif suivant la revendication 6, **caractérisé en ce que** la tranche support (15) est plus grande que la tranche système (14) ou lui est égale.

8. Dispositif suivant la revendication 6, **caractérisé en ce qu'**il est affecté aux tranches supports (10, 15, 24) et aux tranches systèmes (13, 14, 27) des dispositifs (5, 19 ; 6, 20, 26) qui peuvent être commandés séparément et au moyen desquels elle peuvent être manipulées.

9. Dispositif suivant la revendication 8, **caractérisé en ce que** les dispositifs (5, 19 ; 6, 20, 26) pouvant être commandés séparément font partie d'un dispositif (20, 22) de réception dans lequel ont lieu des opérations de liaison et de déliaison.

10. Dispositif suivant la revendication 8, **caractérisé en ce que** les dispositifs pouvant être commandés séparément sont constitués sous la forme de SW-Pin-chucks (6, 20, 26) pour les tranches systèmes (13, 14, 27) et sous la forme de TW-Pin-chucks (5, 19) pour les tranches supports (10, 15, 24).

11. Dispositif suivant la revendication 10, **caractérisé en ce que** les SW-Pin-chucks (6, 20, 26) et les TW-Pin-chucks (15, 19) peuvent être commandés par pression, respectivement par dépression.

12. Dispositif suivant la revendication 10, **caractérisé en ce qu'**au moins les SW-Pin-chucks (6, 20, 26) ont des garnitures (8, 28) d'étanchéité sur lesquelles les tranches systèmes (13, 24, 27) reposent et peuvent être aspirées au moyen du vide.

13. Dispositif suivant la revendication 6, **caractérisé en ce que** le dispositif (1, 22) de réception dispose d'un chauffage (9) de chauffage de piles (2, 21, 29) de tranches qui sont formées par liaison de tranches supports (10, 15, 24) et de tranches systèmes (13, 14, 27) et qui sont séparées par déliaison.

14. Dispositif suivant la revendication 6, **caractérisé en ce qu'**il est conçu de façon à ce que le milieu (12, 18, 30) de liaison puisse être influencé thermiquement par un chauffage (9).

15. Dispositif suivant la revendication 6, **caractérisé en ce que** le dispositif (22) de réception dispose d'un sillon (31) de réception d'un milieu (23) de déliaison.

16. Dispositif suivant la revendication 15, **caractérisé en ce que** le sillon (31) communique avec un dispositif (32) d'évacuation pour l'évacuation du milieu (23) de déliaison.

17. Dispositif suivant la revendication 15, **caractérisé en ce qu'**il est conçu de manière à pouvoir utiliser un solvant comme milieu (23) de déliaison.

18. Dispositif suivant la revendication 6, **caractérisé en ce que** la tranche support (10, 15, 24) est constituée d'un matériau ayant des propriétés physiques, par exemple des coefficients de température, semblables à celles de la tranche système (13, 14, 27) à supporter.

19. Dispositif suivant la revendication 18, **caractérisé en ce que** la tranche support (10, 15, 24) et en un matériau comme du verre au quartz, de la matière plastique ou analogue.
